# EUROPÄISCHE PATENTSCHRIFT

(11) **EP 0 610 360 B1**
(45) Veröffentlichungstag und Bekanntmachung des Hinweises auf die Patenterteilung: **25.10.1995**
(21) Anmeldenummer: 92922851.8
(22) Anmeldetag: 01.11.1992
(51) Int. Cl.: H05K 3/46, H05K 3/20

(54) **VERFAHREN ZUR HERSTELLUNG EINER GEDRUCKTEN SCHALTUNG SOWIE GEDRUCKTE SCHALTUNG**
PROCESS FOR MANUFACTURING A PRINTED CIRCUIT AND PRINTED CIRCUIT
PROCEDE POUR LA FABRICATION D'UN CIRCUIT IMPRIME, AINSI QUE CIRCUIT IMPRIME

(30) Priorität: 31.10.1991 DE 4135839
(43) Veröffentlichungstag der Anmeldung: 17.08.1994
(73) Patentinhaber: PHILIPS ELECTRONICS N.V., 5621 BA Eindhoven (NL)
(72) Erfinder: BRUCKNER, Helmut, D-5208 Eitorf (DE); KÖPNICK, Siegfried, D-5210 Troisdorf (DE); UGGOWITZER, Werner, A-9170 Ferlach (AT)
(74) Vertreter: Stolk, Steven Adolph
(86) Internationale Anmeldenummer: EP9202507
(87) Internationale Veröffentlichungsnummer: WO9309655

(56) Entgegenhaltungen:
- EP-A- 0 146 241
- EP-A- 0 253 892
- DE-A- 2 246 208

## Beschreibung

### Verfahren zur Herstellung einer gedruckten Schaltung sowie gedruckte Schaltung

### Technisches Gebiet

Die Erfindung betrifft ein Verfahren zur Herstellung einer mehrlagigen, d.h. zumindest zweilagigen gedruckten Schaltung entsprechend dem Oberbegriff des Anspruchs 1. Weiterhin ist Gegenstand der vorliegenden Erfindung eine wenigstens zweilagige gedruckte Schaltung entsprechend dem Oberbegriff des Anspruchs 7.

Mehrlagige gedruckte Schaltungen mit zwei oder mehr untereinander durch Durchkontaktierungen verbundene Leiterebenen werden in der Elektronik-Industrie in großem Umfang eingesetzt. Gedruckte Schaltungen mit mindestens drei Ebenen werden als Multilayer bezeichnet.

### Stand der Technik

Zur Erzeugung elektrisch leitender Verbindungen zwischen den einzelnen Leiterebenen von mehrlagigen gedruckten Schaltungen sind Verfahren zur elektrisch-chemischen Metallisierung (Durchkontaktierung) von zuvor gebohrten oder gestanzten Löchern bekannt. Diese Art der Durchkontaktierung wird normalerweise nur bei Epoxidharz-Glas-Laminaten angewendet und ist technisch äußerst aufwendig und daher teuer.

Bei zweilagigen gedruckten Schaltungen aus beidseitig kupferkaschierten Basismaterialien ist es bekannt, die elektrisch leitende Verbindung von Leiterbahnen der beiden Ebenen durch Eindrücken einer elektrisch leitenden Paste in zuvor gebohrte Löcher herzustellen. Die Leitpaste wird anschließend unter Einwirkung höherer Temperaturen ausgehärtet. Dieses Verfahren leidet an mangelnder Zuverlässigkeit der Kontaktierung.

Aus der DE-A-15 40 249, der EP-A2-0 137 279 und der FR-A-1.464.288 sind jeweils Verfahren bekannt, bei denen auf eine Trägerplatte eine weitere, relativ dünne Leiterplatten-Lage aus einer Trägermaterialschicht mit fertig geätztem Leiterbild aufgebracht wird. Die elektrisch leitende Verbindung der Kontakt- bzw. Anschlußflächen der einzelnen Ebenen erfolgt durch Löten, wobei die Kontaktierung nur im Bereich von Bauteil-Anschlußdrähten erfolgt. Hierdurch ist die praktische Verwendbarkeit des Verfahrens stark eingeschränkt.

Ein ähnliches Verfahren ist aus der US-A-3,052,823 bekannt, wobei die aufkaschierte zweite oder weitere Leiterplatten-Lage Öffnungen aufweist, um Zugang zu den Kontaktflächen der jeweils darunter liegenden Leiterebene zu erhalten. Die Kontaktierung erfolgt durch Löten im Randbereich dieser Öffnungen, wobei nebeneinander liegende Kontakt- bzw. Anschlußstellen direkt, d. h. ohne Mithilfe von Anschlußdrähten, verbunden werden können. Dieses Verfahren arbeitet nur bei Handlötung mit ausreichender Zuverlässigkeit, so daß sich ein großindustrieller Einsatz nicht durchsetzen konnte.

Aus der DE-B1-19 23 199 ist ein Verfahren zur Herstellung einer Schaltungsplatte mit mindestens zwei durch isolierende Lagen voneinander getrennten Leiterebenen bekannt, bei dem die Leiterebenen punktweise mittels z. B. mit Lötzinn beschichteter Kontaktflecken durch Öffnungen in den isolierenden Lagen verbunden werden. Die Kontaktierung erfolgt durch Pressen unter selektivem Druck auf die Kontaktflächen, wobei die äußere Lage auf die innere Lage gepreßt und mit dieser verbunden wird. Ein ähnliches Verfahren ist auch aus der US-A-4,319,708 bekannt. Diese Verfahren sind äußerst aufwendig und erlauben nicht die Herstellung von mehrschichtigen Leiterplatten mit großer Bestückungsdichte.

Eine mehrlagige gedruckte Schaltung wird in der EP-A-0 146 241 beschrieben. Dabei werden auf den gegenüberliegenden Oberflächen von mindestens zwei Trägermaterialien und einem dazwischen liegenden Trägermaterial Leiterbahnen, die aus einer leitfähigen Harzmischung bestehen, angebracht. An bestimmten Stellen wird das Trägermaterial gelocht und alle Trägermaterialien anschließend thermokaschiert. Es entsteht eine mehrlagige gedruckte Schaltung ohne Erhebungen und beidseitig außenliegendem Trägermaterial. Die hier vorgeschlagene Technik läßt sich jedoch nicht bei metallischen Leiterbahnen anwenden.

Aus der DE-A1-31 52 603 (= EP-A1-0 067 231) ist schließlich ein gattungsgemäßes Verfahren bekannt, bei dem auf eine Trägerplatte mit einer ersten Leiterebene und Kontaktflächen zunächst eine Isolationsschicht aufgebracht wird, die die Kontaktflächen freiläßt. Auf diese Isolationsschicht wird über eine Kleber schicht eine Kupferfolie aufkaschiert, wobei Kleberschicht und Kupferfolie an den Stellen Löcher aufweisen, an denen sich die Kontaktflächen der ersten Leiterebene befinden. Anschließend wird aus der Kupferfolie durch Ätzen die zweite Leiterebene mit Anschlußflächen erzeugt, wobei die Anschlußflächen als Lötaugen ausgebildet sind, die die Löcher in der Kleberschicht umschließen. Die Kontaktierung der Lötaugen mit den Kontaktflächen erfolgt durch Aufbringen eines leitfähigen Materials wie Silberleitpaste oder Lötzinn. Bei diesem Verfahren sind die Kontaktflächen der ersten Leiterebene von den Lötaugen der zweiten Leiterebene nur durch die Dicke der Kleberschicht getrennt. Dennoch ist ein Verbinden der Kontaktflächen mit den Lötaugen durch automatisches Löten, z.B. im Wellen-Lötbad, nicht ausreichend sicher. Ein ähnliches Verfahren wird auch in der DE-A1 27 16 545 beschrieben.

### Aufgabe

Es ist daher Aufgabe der vorliegenden Erfindung, ein Verfahren entsprechend dem Oberbegriff des Anspruchs 1 und eine wenigstens zweilagige gedruckte Schaltung entsprechend dem Oberbegriff des Anspruchs 7 dahingehend zu verbessern, daß die elektrisch leitenden Verbindungen zwischen den Kontaktflächen der ersten Leiterebene und den korrespondierenden Anschlußflächen der zweiten Leiterebene einfach und zuverlässig erfolgen können.

### Darstellung der Erfindung

Die Erfindung löst diese Aufgabe durch ein gattungsgemäßes Verfahren mit den kennzeichnenden Merkmalen des Anspruchs 1 bzw. durch eine wenigstens zweilagige gedruckte Schaltung entsprechend dem Anspruch 7.

Zunächst wird auf eine wenigstens einseitig mit einer ersten Leiterebene versehene Trägerplatte eine kleberbeschichtete leitende Folie unter Einwirkung eines hohen Drucks von 50 bis 150 bar, insbesondere von 80 bis 120 bar, und bei einer Temperatur von mindestens 80 °C kaschiert. Das Verpressen erfolgt bevorzugt in Etagenpressen, wobei das Laminat für wenigsten 5 min eine Temperatur von über 140 °C aufweisen sollte. Bei diesen Preßbedingungen erweicht das Material der Trägerplatte, so daß die Kontaktflächen der ersten Leiterebene wenigstens partiell, d.h. in einem Teilbereich ihrer Fläche, durch die Löcher der kleberbeschichteten leitenden Folie in Richtung der Oberfläche der leitenden Folie gewölbt werden. Diese Aus- bzw. Hochwölbung der Kontaktflächen der ersten Leiterebene erfolgt nur an den Stellen, an denen die gelochte leitende Folie Löcher aufweist, da an diesen Stellen beim Verpressen der Gegendruck fehlt oder zumindest geringer ist.

Die mit der ersten Leiterebene versehene Trägerplatte kann in an sich bekannter Weise z. B. durch Ätzen (Subtraktivverfahren) aus einem kupferbeschichteten Laminat (Basismaterial) hergestellt werden. Es können jedoch auch andere nach dem Stand der Technik bekannte Verfahren, wie Additivtechnik o. dgl., eingesetzt werden.

Als Trägerplatte wird bevorzugt ein Laminat aus mit Harz getränkten Papierlagen verwendet, insbesondere Phenolharz-Papierlaminate (FR-2), wie sie z. B. unter der Handelsbezeichnung Trolitax ^{R} DN 8034 von der Fa. Hüls Troisdorf AG vertrieben werden. Das Harz sollte bei dem Aufkaschieren der mit dem Kleber versehenen gelochten leitenden Folie unter den Preßbedingungen wenigstens so weit erweichen, daß die gewünschte Aus- bzw. Hochwölbung des z. B. Kupfermaterials der Kontaktflächen der ersten Leiterebene durch die Löcher der aufkaschierten leitenden Folie in Richtung der Oberfläche der leitenden Folie bzw. Anschlußflächen der zweiten Leiterebene möglich wird.

Die eine Kleberschicht aufweisende, gelochte leitende Folie wird nach einer bevorzugten Ausführungsform der Erfindung unmittelbar, d. h. ohne zusätzliche Isolationsschicht, auf die die erste Leiterebene aufweisende Trägerplatte kaschiert. Der Kleber bildet dabei die einzige Isolierung (Isolationsschicht) zwischen der ersten und der zweiten Leiterebene.

Nach einer bevorzugten Ausführungsform der Erfindung wird als Kleber ein heißerweichbarer Acrylat-Kleber verwendet. Bevorzugt weist die Kleberschicht eine Dicke von 20 bis 150 µm, insbesondere von 35 bis 60 µm auf. Es hat sich überraschend herausgestellt, daß der Isolationswiderstand zwischen der ersten und der zweiten Leiterebene trotz der äußerst geringen Stärke der Kleberschicht auch an Kreuzungspunkten der Leiter völlig ausreichend ist. Der Kleber weist bevorzugt eine Glasübergangstemperatur von 50 - 70 °C auf.

Die eine Kleberschicht aufweisende leitende Folie wird z. B. durch Stanzen an den Stellen mit einem Loch versehen, an denen später eine Kontaktierung, d. h. eine leitende Verbindung, zwischen den Kontaktflächen der Leiter der ersten Ebene und einer Anschlußfläche eines Leiters der zweiten Ebene erfolgen soll. Die Löcher sind bevorzugt kleiner als die korrespondierenden Kontaktflächen der ersten Leiterebene, wobei die Flächen der Löcher - in der Projektion gesehen - nach dem Aufkaschieren des Schichtstoffes jeweils vollständig innerhalb der Flächen der korrespondierenden Kontaktflächen liegen.

Nach dem Stanzen der kleberbeschichteten leitenden Folie wird diese auf der mit der ersten Leiterebene versehenen Trägerplatte fixiert, z. B. durch einige Klebepunkte im Randbereich. Anschließend wird die gelochte leitende Folie mit der Trägerplatte laminiert. Das Laminieren des gelochten Schichtstoffes mit der Trägerplatte erfolgt bevorzugt bei einer Temperatur oberhalb der Glasübergangstemperatur T_{G} des Harzes der Trägerplatte, insbesondere bei einer Temperatur von 140 bis 180 °C. Das hierdurch erzielte Auswölben der Kontaktflächen der ersten Leiterebene in die Löcher der aufkaschierten kleberbeschichteten leitenden Folie begünstigt entscheidend das spätere elektrisch leitende Verbinden der Kontaktflächen der ersten Leiterebene mit den Anschlußflächen der zweiten Leiterebene, so daß diese Verbindung insbesondere durch automatisches Löten, beispielsweise in einem Wellen- bzw. Schwall-Lötbad, mit hoher Zuverlässigkeit erfolgen kann. Nach dem Verpressen beträgt der Abstand zwischen der Oberfläche der Kontaktflächen (an deren höchster Erhebung) zu der Oberflächen-Ebene der leitenden Folie weniger als die Dicke der leitenden Folie, bevorzugt weniger als die halbe Dicke der leitenden Folie und insbesondere weniger als 10 µm.

Nach dem Laminieren wird z. B. in an sich bekannter Weise aus der leitenden Folie die obere Leiterebene geätzt, so daß lediglich das obere Leiterbild mit den Anschlußflächen von der leitenden Folie übrig bleibt. An den Stellen, an denen die leitende Folie die Löcher aufweist, befinden sich die Anschlußflächen der oberen Leiterebene, die die Löcher des aufkaschierten Schichtstoffes zumindest berühren und bevorzugt ganz umschließen und somit jeweils ein Lötauge bilden. Durch die Lötaugen-Löcher und die Löcher in der Kleberschicht werden die darunter liegenden Kontaktflächen der ersten Leiterebene sicht-bar.

Bevorzugt wird die mehrlagige gedruckte Schaltung nach dem Ätzen in an sich bekannter Weise mit einem Lötstopplack versehen, gebohrt bzw. gestanzt, bestückt und anschließend automatisch verlötet. Dabei wird der Lötstopplack so auf die zweite Leiterebene aufgebracht, daß von den Anschlußflächen der zweiten Leiterebene jeweils eine mit Lot benetzbare Fläche ausgespart wird. Diese Flächen ohne Lötstopplack weisen z. B. die Form eines Lötauges auf, das den durch das Loch in der Kleberschicht sichtbaren Teil der Kontaktflächen der ersten Leiterebene umschließt. Hierdurch wird eine besonders zuverlässige Verbindung der Kontaktflächen mit den Anschlußflächen erreicht, da sich das flüssige Lot gleichmäßig auf beide Flächen (Kontaktflächen und Anschlußflächen) verteilt.

Beim Verlöten werden die Kontaktflächen der ersten Leiterebene an jenen Stellen, an denen die aufkaschierte kleberbeschichtete leitende Folie die Löcher aufwies, mit den korrespondierenden Anschlußflächen der zweiten Leiterebene elektrisch leitend verbunden. Ggf. kann das elektrisch leitende Verbinden der Kontaktflächen der ersten Leiterebene mit den korrespondierenden Anschlußflächen der zweiten Leiterebene auch durch Auftragen und Aushärten einer elektrisch leitenden Paste, z. B. einer Silberpaste, erfolgen. Eine Verbindung durch Löten ist jedoch preiswerter und daher bevorzugt.

Da nicht ganz ausgeschlossen werden kann, daß beim Laminieren der eine Kleberschicht aufweisenden, gelochten leitenden Folie mit der Trägerplatte eine geringe Menge des Klebers in die Löcher in der leitenden Folie eindringt und damit die Kontaktflächen der ersten Leiterebene teilweise bedeckt, wird nach einer bevorzugten Ausführungsform der Erfindung vorgeschlagen, Löcher durch die Trägerplatte innerhalb der Anschlußflächen bzw. Lötaugen der oberen Leiterebene vorzusehen. Diese Löcher, z. B. mit einem Durchmesser von 0,7 mm, durchdringen somit die Anschlußflächen bzw. Lötaugen der oberen (zweiten) Leiterebene, die Kontaktflächen der ersten Leiterebene sowie die Trägerplatte vollständig. Beim Löten im Wellen- bzw. Schwall-Lötbad kann der zumindest teilweise durch die hohe Temperatur des Lotes vergasende Kleber-Rest durch diese Entgasungslöcher auf die gegenüberliegende Leiterplatten-Oberfläche abgeleitet werden. Hierdurch kann die Zuverlässigkeit der Lötverbindung weiter gesteigert werden.

Das erfindungsgemäße Verfahren ermöglicht in überraschend einfacher und kostengünstiger Weise die Herstellung von mehrlagigen gedruckten Schaltungen mit einer ersten Leiterebene und einer hiervon durch eine Kleberschicht getrennten zweiten Leiterebene, wobei die erste Leiterebene Kontaktflächen (Pads) und die zweite Leiterebene hierzu korrespondierende Anschlußflächen (Lötaugen) aufweisen und wobei die Kontaktflächen und die korrespondierenden Anschlußflächen miteinander elektrisch leitend verbunden werden können. Dadurch, daß die Kleberschicht an den Stellen, an denen die Kontaktflächen mit den korrespondierenden Anschlußflächen miteinander elektrisch leitend verbunden werden können, Löcher aufweist, durch die die Kontaktflächen der ersten Leiterebene wenigstens partiell in Richtung der Oberfläche der Anschlußflächen der zweiten Leiterebene gewölbt sind, und daß die Oberflächen der Kontaktflächen jeweils einen Abstand zur Oberfläche der Anschlußflächen der zweiten Leiterebene aufweisen, der kleiner ist als die Dicke der Anschlußflächen, werden auch durch automatisches Löten elektrisch leitende Verbindungen mit besonders hoher Zuverlässigkeit erreicht.

Besonders vorteilhaft ist es, wenn die Löcher der Isolationsschicht kleiner sind als die korrespondierenden Kontaktflächen der ersten Leiterebene und wenn die Flächen der Löcher - in der Projektion gesehen - jeweils vollständig innerhalb der Flächen der korrespondierenden Kontaktflächen liegen.

Soweit in dieser Beschreibung von einer ersten und einer zweiten Leiterebene gesprochen wird, schließt dieses ein, daß auch weitere Leiterebenen in entsprechender Weise aufgebracht werden können. Weiterhin ist es möglich, von einem beidseitig kupferkaschierten Trägerplatten-Material auszugehen, um so durch einseitige Beschichtung mit einer leitenden Folie zu einer insgesamt dreilagigen Schaltung oder durch beidseitiges Aufbringen jeweils einer leitenden Folie zu einer vierlagigen gedruckten Schaltung zu gelangen.

### Kurze Beschreibung der Zeichnungen

Die Erfindung wird nachfolgend anhand eines Ausführungsbeispiels sowie der Zeichnung näher erläutert. Es zeigen dabei
- Figur 1: eine Trägerplatte mit der ersten Leiterebene im Schnitt,
- Figur 2: eine Aufsicht auf die Trägerplatte gemäß Fig. 1,
- Figur 3: die gelochte leitende Folie mit Kleberschicht im Schnitt,
- Figur 4: die Trägerplatte mit darauf fixierter gelochter leitender Folie im Schnitt,
- Figur 5: eine Aufsicht auf die Trägerplatte gemäß Fig. 4,
- Figur 6: einen Schnitt durch die Leiterplatte nach dem Laminieren,
- Figur 7: einen Schnitt durch die Leiterplatte nach dem Ätzen der oberen leitenden Folie,
- Figur 8: einen Schnitt durch die Leiterplatte nach Aufbringen des Lötstopplacks,
- Figur 9: einen Schnitt durch die bestückte und gelötete zweilagige gedruckte Schaltung,

wobei die Fig. nicht maßstäblich dargestellt sind.

### Bester Weg zur Ausführung der Erfindung

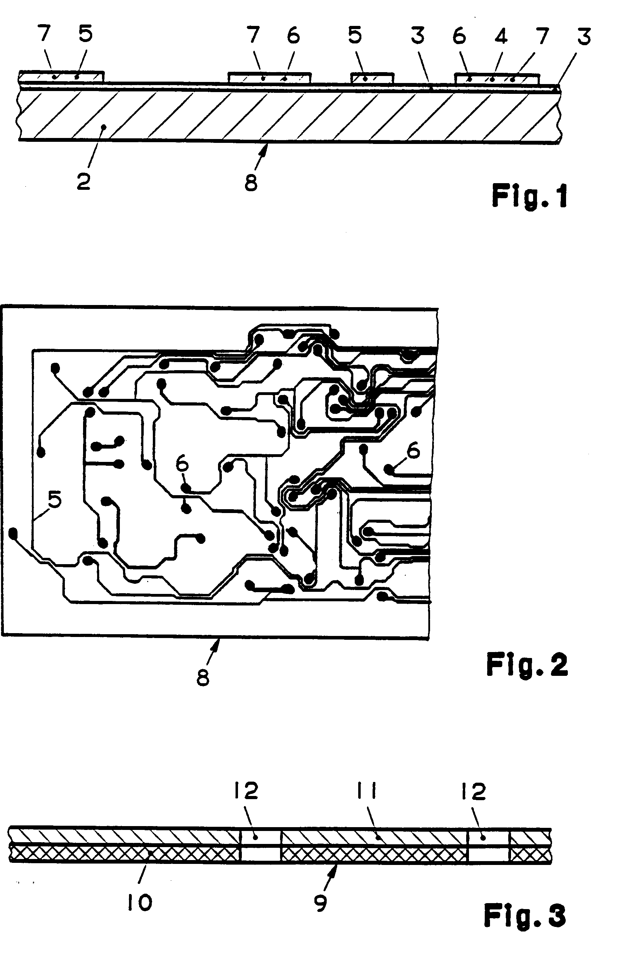

In dem nachfolgend dargestellten Ausführungsbeispiel der Erfindung wird zunächst ausgegangen von einem handelsüblichen einseitig kupferkaschierten Basismaterial mit 35 µm Kupferbeschichtung. Dieses Basismaterial (Laminat) ist unter der Bezeichnung Trolitax ^{R} DN 8034 von der Fa. Hüls Troisdorf AG lieferbar. Das Laminat besteht aus einer Trägerplatte 2 auf Basis von Phenol-Hartpapier, einer Kleberschicht 3 sowie einer Kupferfolie 4. In an sich bekannter Weise wird durch Ätzen aus dem Laminat eine Leiterplatte 8 mit einer (ersten) Leiterebene 7 mit Leiterbahnen 5 und Kontaktflächen (Pads) 6 hergestellt (Fig. 1).

Aus Figur 2 ist ersichtlich, daß die Kontaktflächen 6 etwa kreisförmige oder ovale Form aufweisen. Die genaue Form dieser Kontaktflächen 6 ist unkritisch, da nur die Form der Löcher 12 in der kleberbeschichteten gelochten Kupferfolie 9 die spätere Form der lötbaren Kontaktflächen 6 bestimmt.

Zur Herstellung der eine Kleberschicht aufweisenden, gelochten leitenden Folie wird eine Kupferfolie 11 einer Stärke von 35 µm mit einer Kleberschicht 10 einer Stärke von 40 µm versehen. Als Kleber wird ein handelsüblicher Acrylat-Kleber eingesetzt, der in den B-Zustand (an-)gehärtet wird, wobei eine Glas(übergangs)temperatur T_{G} von 60 °C eingestellt wird. Wichtig ist, daß der die Kleberschicht 10 bildende Kleber nur so weit vernetzt, daß eine ausreichende Klebfähigkeit bestehen bleibt, um eine ausreichende Lagenbindung im späteren Laminat 1 zu erreichen. Andererseits sollte der Kleber eine genügend hohe Viskosität aufweisen, um beim Verpressen ein Austreten des Klebers in die Löcher 12 der Kupferfolie 11 weitgehend zu unterdrücken.

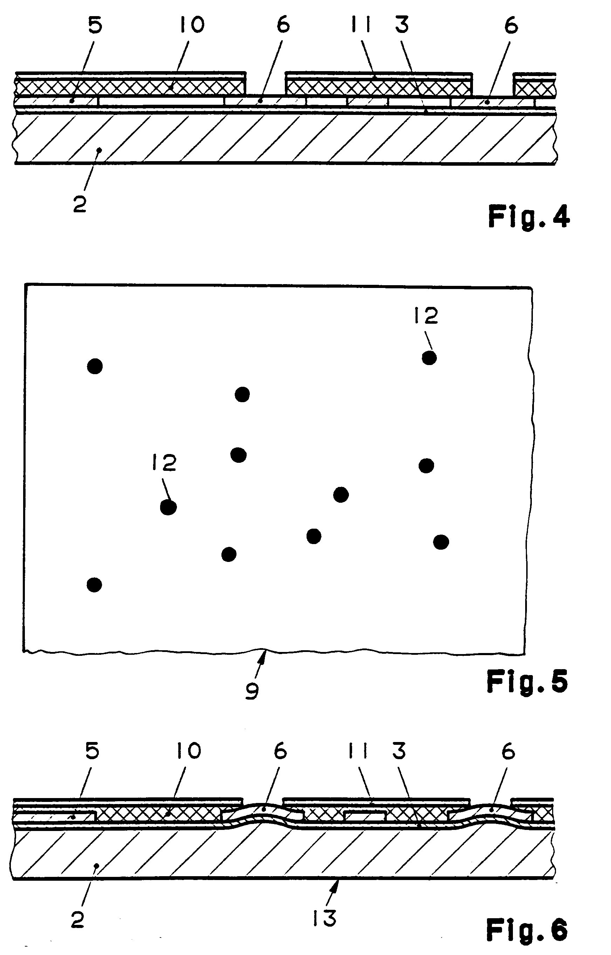

Die mit der Kleberschicht 10 versehene Kupferfolie 11 (leitende Folie) wird anschließend mit einem Stanzwerkzeug gelocht, so daß an jeder Stelle, an der eine Kontaktierung 17 zwischen den Kontaktflächen 6 der ersten Leiterebene 7 und den entsprechenden Anschlußflächen 16 der zweiten Leiterebene 19 vorgesehen ist, ein Loch 12 durch die kleberbeschichtete Folie 9 gestanzt wird. Die Löcher 12 weisen eine kreisförmige Form auf, wie insbesondere aus Figur 5 zu erkennen ist.

Der gestanzte Folie 9 (Fig. 3) wird anschließend paßgenau auf die geätzte Leiterplatte 8 gelegt, durch einige Klebepunkte fixiert und in einer Etagenpresse bei einem Druck von 100 bar verpreßt. Die Presse wird dabei auf eine Temperatur von ca. 160 °C beheizt. Das aus der geätzten Leiterplatte 8 und der gestanzten Folie 9 gebildete Laminat 13 wird beim Verpressen durch Wärmeleitung innerhalb von ca. 20 min auf 160 °C erwärmt. Anschließend wird es unter Beibehaltung des Drucks innerhalb von weiteren 30 min abgekühlt.

Während des Preßvorgangs erweicht die Kleberschicht 10 sowie die Trägerplatte 2 der geätzten Leiterplatte 8. Da an den Stellen, an denen der Folie 9 die Löcher 12 aufweist, der Preßdruck fehlt oder zumindest geringer ist, werden die unter den Löchern 12 liegenden Bereiche der Kontaktflächen 6 der ersten Leiterebene 7 durch die Löcher 12 nach oben in Richtung der Oberfläche der zweiten Leiterebene 19 gewölbt. Dieser Effekt ist in Fig. 6 gut erkennbar. Durch dieses partielle Hochwölben der Kontaktflächen 6 durch die Löcher 12 wird ein Eindringen des Klebers der Kleberschicht 10 in die Löcher 12 weitgehend unterbunden. Gleichzeitig werden die (hochgewölbten) Oberflächen der Kontaktflächen 6 und die Oberflächen der benachbarten Anschlußflächen 16 bis auf einen geringen Abstand, der geringer ist als die Dicke der Anschlußflächen 16, angenähert, so daß eine spätere Kontaktierung durch Löten vereinfacht wird. Beim Verpressen verteilt sich der Kleber der Kleberschicht 10 in die Zwischenräume zwischen den Leiterbahnen 5 und den Kontaktflächen 6 der ersten Leiterebene 7, wobei eine Isolationsschicht 23 zwischen den Leiterbahnen 5 und der Kupferfolie 11 verbleibt. Die im Ausführungsbeispiel gewählte Dicke der Kleberschicht 10 von 40 µm garantiert bei der verwendeten Leiterdicke der ersten Leiterebene 7 von 35 µm eine verbleibende Isolationsdicke von ca. 15 bis 20 µm, was zu einer ausreichenden Isolation führt.

Je nach Härte bzw. Viskosität des verwendeten Klebers der Kleberschicht 10 und des Harzes der Trägerplatte 2 können die Leiterbahnen 5 der ersten Leiterebene 7 beim Verpressen auch ganz oder teilweise in die Oberfläche der Trägerplatte 2 eingedrückt werden, so daß die Dicke der verbleibenden Isolationsschicht 23 annähernd der ürsprünglichen Dicke der Kleberschicht 10 entspricht (in den Fig. nicht dargestellt).

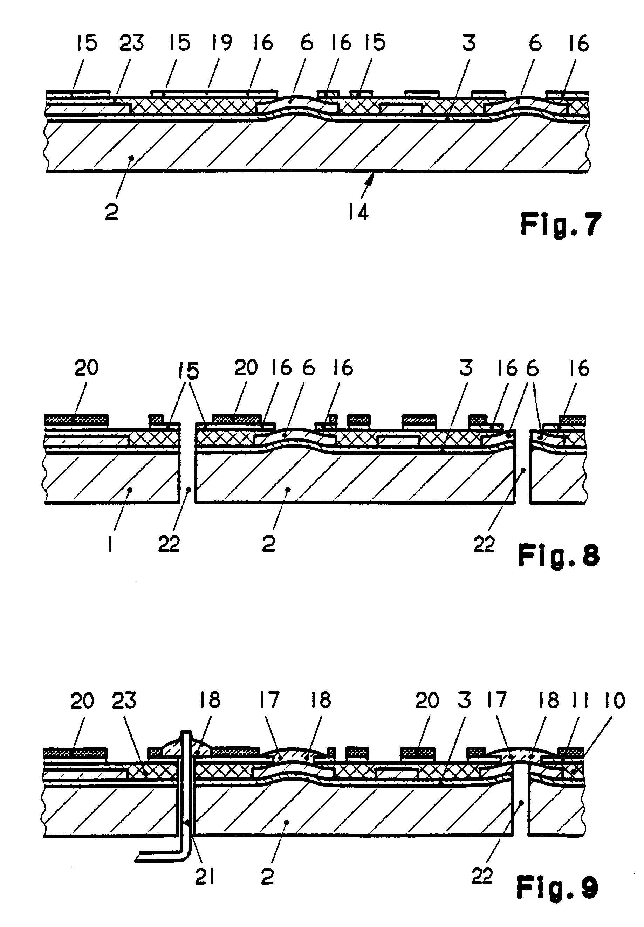

Im Anschluß an das Laminieren wird die obere Kupferfolie (leitende Folie 11) in an sich bekannter Weise mit Ausnahme der zweiten Leiterebene 19 abgeätzt, so daß von der Kupferfolie (leitende Folie 11) lediglich die Leiterbahnen 15 und die Anschlußflächen 16 übrig bleiben (Fig. 7).

Das geätzte Laminat 14 wird anschließend in herkömmlicher Weise mit einem Lötstopplack 20 versehen. Hierbei werden die oberen Anschlußflächen 16 in der Weise begrenzt, daß sie die Form von Lötaugen einnehmen, die die durch die Löcher 12 sichtbaren Bereiche der Kontaktflächen 6 umschließen.

Nach dem Aufbringen des Lötstopplacks 20 wird die mehrlagige gedruckte Schaltung 1 in an sich bekannter Weise gebohrt (Löcher 22), bestückt (Fig. 8, Fig. 9) und anschließend im Wellen-Lötbad automatisch verlötet. Hierbei werden einerseits die Bauteil-Anschlußdrähte 21 mit den oberen Leiterbahnen 15 der zweiten Leiterebene 19 durch das Lötzinn 18 verbunden. Die Anschlußdrähte 21 können auch mit entsprechenden Lötaugen der ersten Leiterebene verbunden werden (nicht dargestellt), soweit die Kleberschicht 10 an den entsprechenden Stellen entweder vorher entfernt wird oder durch ein größeres Loch in der Folie 9 ausgespart wird.

In Fig. 9 ist die Kontaktierung 17 zwischen der Anschlußfläche 16 und der darunterliegenden Kontaktfläche 6 durch das Lot 18 dargestellt. Ggf. kann durch eine Entgasungsbohrung 22, die die Anschlußfläche 16, die Kontaktfläche 6 sowie die Trägerplatte 2 durchdringt, eine Verbesserung der Zuverlässigkeit der Lötverbindung erreicht werden.

Für die Zuverlässigkeit der Löt-Kontaktierung ist es wesentlich, daß die Oberfläche der Kontaktfläche 6 möglichst wenig Kleber-Reste aufweist und daß die Oberfläche der Kontaktfläche 6 möglichst weit durch die Löcher 12 der kleberbeschichteten gelochten Kupferfolie 9 gedrückt wurden und somit annähernd auf dem gleichen Oberflächenniveau liegen wie die Anschlußflächen 16. Durch Wahl der mit dem Lot 17 benetzbaren Fläche der Kontaktfläche 6 und der Anschlußfläche 16 wird erreicht, daß durch Oberflächenspannungs-Effekte eine gleichmäßige Verteilung des Lötzinns 18 erzielt wird.

In gleicher Weise, in der die obere Leiterebene 19 aufgebracht und kontaktiert wird, kann auch die Rückseite der Trägerplatte 2 mit einer oder zwei zusätzlichen Leiterebenen versehen werden.

### Legende

1 mehrlagige gedruckte Schaltung
2 Trägerplatte
3 Kleber (erste Leiterebene)
4 Kupferschicht (erste Leiterebene)
5 Leiterbahn (erste Leiterebene)
6 Kontaktfläche (erste Leiterebene), Pad
7 erste Leiterebene
8 geätzte Leiterplatte (einseitig)
9 Folie (kleberbeschichtete gelochte Kupferfolie)
10 Kleberschicht (zweite Leiterebene)
11 leitende Folie (zweite Leiterebene)
12 Loch
13 Laminat vor Ätzen
14 Laminat nach Ätzen
15 obere Leiterbahn
16 Anschlußfläche (zweite Leiterebene), Lötauge
17 elektrisch leitende Verbindung, Kontaktierung
18 Lötzinn
19 zweite Leiterebene
20 Lötstopplack
21 Bauteil-Anschlußdraht
22 Loch
23 Isolationsschicht

## Patentansprüche

1. Verfahren zur Herstellung einer zumindest zweilagigen gedruckten Schaltung (1) mit einer Trägerplatte (2), einer ersten Leiterebene (7) mit Kontaktflächen (6) und einer zweiten Leiterebene (19) mit Anschlußflächen (16), bei dem
- auf die Trägerplatte (2) mit der ersten Leiterebene (7) und den Kontaktflächen (6) eine mit einer Kleberschicht (10) versehene leitende Folie (11) bei einer Temperatur von mehr als 80 °C aufkaschiert wird,
- wobei die Kleberschicht (10) und die leitende Folie (11) Löcher (12) aufweisen, die mit den Kontaktflächen (6) der ersten Leiterebene (7) korrespondieren,
- anschließend aus der leitenden Folie (11) die zweite Leiterebene (19) mit den Anschlußflächen (16) erzeugt wird,
- wobei die Anschlußflächen (16) der zweiten Leiterebene (19) an die Löcher (12) in der Kleberschicht (10) angrenzen,
- wonach die Kontaktflächen (6) der ersten Leiterebene (7) mit den korrespondierenden Anschlußflächen (16) der zweiten Leiterebene (19) durch die Löcher (12) der Kleberschicht (10) durch Löten oder durch Auftragen einer leitfähigen Paste elektrisch leitend verbunden werden können,
***dadurch gekennzeichnet***, daß
- die mit der Kleberschicht (10) versehene, gelochte leitende Folie (11) mit der die erste Leiterebene (7) aufweisenden Trägerplatte (2) bei einem Druck von 50 bis 150 bar kaschiert wird,
- wobei die Kontaktflächen (6) der ersten Leiterebene (7) wenigstens partiell durch die Löcher (12) der Kleberschicht (10) und der leitenden Folie (11) in Richtung der Oberfläche der leitenden Folie (11) gewölbt werden,
- so daß - nach Erzeugung der zweiten Leiterebene (19) mit den Anschlußflächen (16) aus der leitenden Folie (11) - die Oberflächen der Kontaktflächen (6) jeweils einen Abstand zur Oberfläche der Anschlußflächen (16) der zweiten Leiterebene (19) aufweisen, der kleiner ist als die Dicke der Anschlußflächen (16).

2. Verfahren nach Anspruch 1, ***dadurch gekennzeichnet***, daß die Kleberschicht (10) aus einem heißerweichbaren Acrylat-Kleber mit einer Glasübergangstemperatur T_{G} von 50 - 70 °C und einer Dicke von 20 bis 150 µm, vorzugsweise 35 bis 60 µm, besteht.

3. Verfahren nach einem der Ansprüche 1 oder 2, ***dadurch gekennzeichnet***, daß die Kontaktflächen (6) der ersten Leiterebene (7) mit den korrespondierenden Anschlußflächen (16) der zweiten Leiterebene (19) durch automatisches Löten in einem Wellen-Lötbad verbunden werden.

4. Verfahren nach Anspruch 3, ***dadurch gekennzeichnet***, daß vor dem Löten durch die Anschlußflächen (16) und die Kontaktflächen (6) der beiden Leiterebenen (7,19) Löcher (22) gebohrt oder gestanzt werden, die die Trägerplatte (2) durchdringen.

5. Verfahren nach einem der Ansprüche 1 bis 4, ***dadurch gekennzeichnet***, daß als Trägerplatte (2) ein Laminat aus mit Harz getränkten Papierlagen verwendet wird.

6. Verfahren nach Anspruch 5, ***dadurch gekennzeichnet***, daß die mit der Kleberschicht (10) versehene, gelochte leitende Folie (11) mit der die erste Leiterebene (7) aufweisenden Trägerplatte (2) unter Einwirkung eines Drucks von 80 bis 120 bar bei einer Temperatur oberhalb von 140 °C kaschiert wird.

7. Wenigstens zweilagige gedruckte Schaltung (1) mit einer ersten Leiterebene (7) und einer hiervon durch eine Kleberschicht (10) getrennten zweiten Leiterebene (19),
- wobei die erste Leiterebene (7) Kontaktflächen (6) und die zweite Leiterebene hierzu korrespondierende Anschlußflächen (16) aufweisen und
- wobei die Kontaktflächen (6) und die korrespondierenden Anschlußflächen (16) miteinander elektrisch leitend verbunden werden können,
- wobei die Kleberschicht (10) an den Stellen, an denen die Kontaktflächen (6) mit den korrespondierenden Anschlußflächen (16) miteinander elektrisch leitend verbunden werden können, Löcher (12) aufweist,
***dadurch gekennzeichnet***, daß
- die Kontaktflächen (6) der ersten Leiterebene (7) wenigstens partiell durch die Löcher (12) der Kleberschicht (10) in Richtung der Oberfläche der Anschlußflächen (16) der zweiten Leiterebene (19) gewölbt sind,
- und daß die Oberflächen der Kontaktflächen (6) jeweils einen Abstand zur Oberfläche der Anschlußflächen (16) der zweiten Leiterebene (19) aufweisen, der kleiner ist als die Dicke der Anschlußflächen (16).

## Claims

1. Method for producing a printed circuit board (1) having at least two layers and having a support plate (2), a first conductor layer (7) with contact areas (pads 6) and a second conductor layer (19) with connecting areas (lands 16), in which
- a conductive foil (11), provided with an adhesive coating (10), is laminated onto the support plate (2) having the first conductor layer (7) and the contact areas (pads 6), at a temperature of more than 80°C,
- the adhesive coating (10) and the conductive foil (11) having holes (12) which correspond to the contact areas (pads 6) of the first conductor layer (7),
- the second conductor layer (19) having the connecting areas (lands 16) is subsequently produced from the conductive foil (11),
- the connecting areas (lands 16) of the second conductor layer (19) adjoining the holes (12) in the adhesive coating (10),
- after which the contact areas (pads 6) of the first conductor layer (7) can be electrically conductively connected to the corresponding connecting areas (lands 16) of the second conductor layer (19) through the hole (12) of the adhesive coating (10), by means of soldering or by the application of a conductive paste,
characterised in that
- the perforated conductive foil (11), provided with the adhesive coating (10), is laminated at a pressure of 50 to 150 bar onto the support plate (2) having the first conductor layer (7),
- the contact areas (6) of the first conductor layer (7) being curved so as to at least partially extend through the holes (12) of the adhesive coating (10) and of the conductive foil (11) in the direction of the surface of the conductive foil (11),
- so that - after subsequently producing the second conductor layer (19) with the connecting areas (16) from the conductive foil (11) - the surfaces of the contact areas (6) are in each case at a distance from the surface of the connecting areas (16) of the second conductor layer (19) which is less than the thickness of the connecting areas (16).

2. Method as claimed in Claim 1, characterized in that the adhesive coating (10) consists of an acrylate adhesive which can be softened by heat and which has a glass transition temperature T_{G} of 50 - 70°C and a thickness of 20 to 150 µm, preferably 35 to 60 µm.

3. Method as claimed in Claim 1 or 2, characterised in that the contact areas of the first conductor layer (7) are connected to the corresponding connecting areas of the second conductor layer (19) by automatic soldering in a wave-soldering bath.

4. Method as claimed in Claim 3, characterised in that, before soldering, holes (22) are drilled or punched through the connecting areas and the contact areas (6) of the two conductor layers (7, 19), which holes (22) pass through the support plate (2).

5. Method as claimed in any one of Claims 1 to 4, characterised in that a laminate consisting of paper layers impregnated with resin is used as the support plate (2).

6. Method according to Claim 5, characterised in that the perforated conductive foil (11), provided with the adhesive coating (10), is laminated to the support plate (2) having the first conductor layer (7), under the influence of pressure of 80 to 120 bar, at a temperature above 140°C.

7. Printed circuit board (1) having at least two layers, comprising a first conductor layer (7) and a second conductor layer (19) which is separated therefrom by an adhesive coating (10),
- the first conductor layer (7) having contact areas (6) and the second conductor layer having connecting areas (16) corresponding thereto, and
- the contact areas (6) and the corresponding connecting areas (16) being interconnectable in an electrically conductive manner,
- the adhesive coating (10) having holes (12) at the points where the contact areas (6) can be electrically conductively connected to the corresponding connecting areas (16),
characterised in that
- the contact areas (6) of the first conductor layer (7) are curved so as to at least partially extend through the holes (12) in the adhesive coating (10) in the direction of the surface of the connecting areas (16) of the second conductor layer (19), which is less than the thickness of the connecting areas (16).

## Revendications

1. Procédé pour la fabrication d'une plaque de circuit imprimé (1) constituée au moins de deux couches, comportant une plaque de support (2), un premier niveau conducteur (7) muni de plages de contact (pads 6) et un deuxième niveau conducteur (19) muni de surfaces de connexion (parties intermédiaires 16), suivant lequel
- à une température supérieure à 80 °C une feuille conductrice (11) munie d'une couche de colle (10) est laminée sur la plaque de support (2) comportant le premier niveau conducteur (7) et les plages de contact (pads 6),
- la couche de colle (10) et la feuille conductrice (11) présentant des trous (12) correspondant aux plages de contact (pads 6) prévues sur le premier niveau conducteur (7),
- est fabriqué ensuite le deuxième niveau conducteur (19) muni de surfaces de connexion (parties intermédiaires 16) en partant de la feuille conductrice (11)
- les surfaces de connexion (parties intermédiaires 16) du deuxième niveau conducteur (19) étant contiguës aux trous (12) percés dans la couche de colle (10),
- après quoi par l'intermédiaire des trous (12) percés dans la couche de colle (10) les plages de contact (pads 6) prévues sur le premier niveau conducteur (7) peuvent être reliées de façon électriquement conductrice aux surfaces de connexion correspondantes (parties intermédiaires 16) prévues sur le deuxième niveau conducteur (19) soit par soudage, soit par apport d'une pâte conductrice,
caractérisé en ce que
- la feuille conductrice perforée (11) munie de la couche de colle (10) est laminée avec la plaque de support (2) munie du premier niveau conducteur (7) à une pression comprise entre 50 et 150 bars,
- les plages de contact (6) prévues sur le premier niveau conducteur (7) sont enfoncées au moins partiellement dans les trous (12) percés dans la couche de colle (10) et dans la feuille conductrice (11) de manière à s'étendre dans la direction de la surface de la feuille conductrice (11),
- de sorte qu'après la fabrication du deuxième niveau conducteur (19) muni des surfaces de connexion (16) en partant de la feuille conductrice (11) - les surfaces des plages de contact (6) présentent chaque fois par rapport à la surface des surfaces de connexion (16) prévues sur le deuxième niveau conducteur (19) un écart qui est inférieur à l'épaisseur des surfaces de connexion (16).

2. Procédé selon la revendication 1, caractérisé en ce que la couche de colle (10) est une colle d'acrylate thermiquement ramollisable présentant une température de transition vitreuse T_{G} comprise entre 50 et 70°C et une épaisseur comprise entre 20 et 150 µm, avantageusement entre 35 et 60 µm.

3. Procédé selon la revendication 1 ou 2, caractérisé en ce que dans un bain de soudure à la vague les plages de contact prévues sur le premier niveau conducteur (7) sont reliées par soudage automatique aux surfaces de connexion correspondantes prévues sur le deuxième niveau conducteur (19).

4. Procédé selon la revendication 3, caractérisé en ce que, avant de n'effectuer l'opération de soudage, on a prévu par perçage ou estampage des trous traversant les surfaces de connexion (16) et les plages de contact (6) prévues sur les deux niveaux conducteurs (7, 19) ainsi que la plaque de support (2).

5. Procédé selon l'une des revendications 1 à 4, caractérisé en ce que l'on utilise comme plaque de support (2) un laminé constitué de couches de papier imprégnées de résine.

6. Procédé selon la revendication 5, caractérisé en ce que la feuille conductrice perforée (11) et munie de la couche de colle (10) est laminée avec la plaque de support (2) présentant le premier niveau conducteur en mettent en oeuvre une pression comprise entre 80 et 120 bars, et à une température supérieure à 140 °C.

7. Plaque de circuit imprimé (1) constituée au moins de deux couches et comportant un premier niveau conducteur (7) et un deuxième niveau conducteur (19) séparé du premier par une couche de colle (10),
- le premier niveau conducteur (7) présentant des plages de contact (6) et le deuxième niveau conducteur présentant des surfaces de connexion (16) correspondant auxdites plages de contact, et
- les plages de contact (6) et les surfaces de connexion (16) correspondantes pouvant être reliées mutuellement de façon électriquement conductrice,
- la couche de colle (10) présentant des trous (12) aux endroits où les plages de contact (6) et les surfaces de connexion (16) correspondantes peuvent être reliées mutuellement de façon électriquement conductrice,
caractérisé en ce que
- les plages de contact (6) prévues sur le premier niveau conducteur (7) sont enfoncées au moins partiellement dans les trous (12) percés dans la couche de colle (10) de manière à s'étendre dans la direction de la surface des surfaces de connexion (16) prévues sur le deuxième niveau conducteur (19),
- et en ce que les surfaces des plages de contact (6) présentent chaque fois par rapport à la surface des surfaces de connexion (16) prévues sur le deuxième niveau conducteur (19) un écart qui est inférieur à l'épaisseur des surfaces de connexion (16).
